# NEW EUROPEAN PATENT SPECIFICATION

(11) **EP 0 329 103 B2**
(45) Date of publication and mention of the opposition decision: **17.03.1999**
(45) Mention of the grant of the patent: 07.06.1995
(21) Application number: 89102584.3
(22) Date of filing: 15.02.1989
(51) Int. Cl.: H01L 39/24, C04B 35/50, C23C 16/40

(54) **Process for manufacturing thin film of high-Tc superconducting oxide**
Verfahren zur Herstellung von dünnen Schichten aus Hochtemperatur-Supraleiteroxyd
Procédé pour la fabrication de couches minces d'oxyde supraconducteur à haute température critique

(30) Priority: 17.02.1988 JP 32594/88; 02.03.1988 JP 49411/88; 16.06.1988 JP 148942/88
(43) Date of publication of application: 23.08.1989
(73) Proprietor: Kabushiki Kaisha Riken, Chiyoda-ku, Tokyo 102-0073 (JP); Research Development Corporation of Japan, Chiyoda-ku Tokyo (JP); Hirai, Toshio, Sendai-shi Miyagi-ken (JP); Yamane, Hisanori, Sendai-shi Miyagi-ken (JP)
(72) Inventor: Kurosawa, Hideyuki c/o KABUSHIKI KAISHA RIKEN, Kumagaya-shi Saitama-ken (JP); Hirai, Toshio, Sendai-shi Miyagi-ken (JP); Yamane, Hisanori, Sendai-shi Miyagi-ken (JP)
(74) Representative: Bühling, Gerhard, Dipl.-Chem.

(56) References cited:
- EP-A- 299 870
- EP-A- 0 055 459
- EP-A- 0 328 333
- WO-A-89/03594
- FR-A- 2 626 110
- US-A- 3 119 707
- US-A- 3 645 778
- US-A- 3 850 665
- US-A- 4 485 094
- PHYSICAL REVIEW LETTERS vol. 58, no. 9, 2 March 1987, pages 908-910, New York, US; M.K. WU et al.: "Superconductivity at 93 K in a New Mixed-Phase Y-Ba-Cu-O Compound System at Ambient Pressure"
- IEEE TRANSACTIONS ON MAGNETICS vol. MAG-23, no. 2, March 1987, pages 999-1002, New York, US; E.J. CUKUAKAS et al.: "Metal organic chemical vapor deposition of the niobium-nitrogen-carbon system"
- APPLIED PHYSICS LETTERS vol. 52, no. 20, 16 May 1988, pages 1743-1745, New York, US, A.D. BERRY et al.: "Formation of high Tc superconducting films by organometallic chemical vapor deposition"
- APPLIED PHYSICS LETTERS vol. 53, no. 18, 31 October 1988, pages 1756-1758, New York, US; A.J. PANSON et al.: "Chemical vapor deposition of YBa2Cu307 using metalorganic chelate precursors"
- Applied Physics Letters, vol. 51, no. 3, 28 September 1987, pages 1027-1029
- Japanese Journal of Applied Physics, vol. 26, no. 9, September 1987, pages L1489-L1491
- Applied Physics Letters, vol. 52, no. 2, 11 January 1988, pages 163-165

## Description

### Background of the Invention

### 1. Field of the Invention

The present invention relates to a process for manufacturing thin film of high-T_{c} superconducting oxide by means of chemical vapor deposition from vaporizing sources containing at least barium, yttrium and copper, the vaporizing sources being the β-diketone complexes of the respective elements.

### 2. Description of the Prior Art

Among known superconducting materials of, such as, element, alloy, compound and organic substance, there have found, for example, Nb₃Sn, V₃Ga and so on their practical use.

For the actual operation of these known materials, it has been inevitable to cool them with liquid helium, what renders necessary to employ large size cooling arrangement of higher cost for practical installations. In recent years, however, two superconducting materials of compositions (La₁₋ₓSrₓ)ₙCuO₄ and Ba₂YCu₃O_{7-y} having superconducting critical temperatures of about 40 °K and 90 °K respectively were found out as ceramic superconduncting material of oxide type. Among these superconducting oxides, in particular, Ba₂YCu₃O_{7-y} has now been under examination for its practical application for, such as, electric generator, electric conductor cable, nuclear magnetic resonance spectrometer, magnetic shielding for Josephson devices and so on, as a superconducting material effective in employing at a temperature of liquid nitrogen (77 °K). For the practical use thereof however, it is necessary to produce it in an adequate form, so that researches have been under development for manufacturing it in a form of, such as, wire, ribbon or conductive film. In particular, as the technique for forming it into thin film, there have been investigated so-called sputtering, vacuum deposition, reaction vapor deposition and so on, whereby superconducting oxide thin films have reportedly been obtained. These techniques are accompanied by a disadvantage of lower deposition rate, rendering difficult to realize deposition on a substrate of large surface or of complicate configuration, so that they are scarcely applicable for producing extended elongate product or product with complicate form.

While techniques of sputtering, electron beam deposition and so on have been employed for producing dense films of superconducting oxide having crystal orientation, such techniques have been difficult to bring into practical use, since restrictions are put in for the substrate with respect to the material and configuration thereof due to the fact that the crystal orientation of the formed film is controlled by epitaxial crystal growth on the substrate of single crystal.

While thin films formed by epitaxial crystal growth on a substrate have been obtained hitherto by the techniques of sputtering, reaction vapor deposition and so on, these techniques are inferior in the productivity due to the indispensable heat treatment for controlling the oxygen content within the deposited film after the film has been formed. And, in particular, the sputtering technique brings forth a further problem of incapability of industrial production due to the difficulty in the control of the chemical composition of the deposited film owing to a possible fluctuation in the composition of the target.

EP-A-0 328 333 (a document according to Article 54 (3) EPC) discloses a vapor deposition process for making barium and/or strontium containing ceramic superconductors employing a temperature in the range of 250 to 650°C.

EP-A-0 299 870 (a document according to Article 54 (3) EPC) teaches to carry out the heat treatment of a thin film deposited on a substrate in the same chamber in which the thin film is deposited on the substrate without taking the substrate out of the chamber. However, there is no suggestion, as to carry out the chemical vapor deposition at a temperature of at least 800°C and below 1000°C nor to use β-diketone complexes as vaporizing sources.

WO-A-89/03 594 (a document according to Arts. 158(1) and (2) in combination with Art. 54(3) and (4) EPC) discloses a process for manufacturing a thin film of high-T_{c} superconducting oxide by means of chemical vapor deposition technique using vaporizing sources for the metal elements constituting the superconducting oxide and a carrier gas with oxygen, comprising the formation of a ceramic thin film by chemical vapor deposition on a substrate at a temperature of at least 300 °C from β-diketone complexes of the elements including at least barium, yttrium and copper. In a specific embodiment, the chemical vapor deposition is conducted by using metal chlorides as the sources for the metal elements, in which case the substrate temperature is set to 1000 °C.

### Summary of the Invention

The present invention has been attained under the contemplation of eliminating the above difficulties and providing a new process for manufacturing high-T_{c} superconducting oxide thin film which permits high deposition rate and allows to effect deposition on a large size substrate having large surface area and to realize production of extended elongate products of complicate configurations.

Therefore, the subject matter of the present invention is to propose a process for manufacturing thin film formed by epitaxial crystal growth, by which the control of the chemical composition of the crystal can be attained simply and stably under exclusion of the heat treatment employed indispensably in the prior art for adjusting the oxygen content in the deposited film after it has been formed and which is suited for industrial manufacturing.

According to the present invention, a process as defined in claim 1 is provided.

In the process according to the present invention, the elements constituting the high-T_{c} superconducting oxide are introduced into the reaction chamber each in the form of a β-diketone complex. The thin film product of high-T_{c} superconducting oxide formed on the substrate has a distinct orientation of epitaxial crystal structure. In the process for manufacturing thin film product of high-T_{c} superconducting oxide under incorporation of the technique of chemical vapor deposition also under the use of vaporizing sources for the elements including at least barium, yttrium and copper, the thin film product of high-T_{c} superconducting oxide is formed by epitaxial crystal growth on the substrate of single crystal.

### Brief Description of the Drawings

Fig. 1 is a schematic illustration of the apparatus capable of employing for realizing the process according to the present invention in a sectional view.

Fig. 2 is an X-ray spectroscopic chart for a zirconia substrate.

Fig. 3 shows the X-ray spectroscopic chart for a film of superconducting oxide deposited on the zirconia substrate.

Fig. 4 is an X-ray spectroscopic chart for a high-T_{c} superconducting oxide of prior art.

Fig. 5 is a diffraction analysis chart obtained by an analytical electron microscope for the superconducting oxide film obtained in one Reference Example.

Fig. 6 is a corresponding diffraction analysis chart obtained by the analytical electron microscope for a conventional high-T_{c} superconducting oxide prepared by sintering.

Fig. 7 is an X-ray spectroscopic chart for the superconducting oxide film obtained in another Reference Example.

Fig. 8 is a corresponding X-ray spectroscopic chart for the superconducting oxide film obtained in a further Reference Example.

Fig. 9 is a corresponding X-ray spectroscopic chart for the superconducting oxide film obtained in a still further Reference Example.

Figs. 10 and 12 show each an X-ray spectroscopic chart for the superconducting oxide film formed on the substrate for the Examples of the invention.

Fig. 11 is a graph showing the relationship between the specific resistance of the superconducting oxide film formed on a substrate in one Example of the invention realtive to the temperature thereof.

### Detailed Description of the Invention

In the process according to the present invention, the vaporizing sources employed consist of β-diketone complexes of an alkaline earth element, of a rare earth element and of copper. These three vaporizing sources are heated each to a temperature sufficient to establish each contemplated vapor pressure of the complex. The vaporized complexes are introduced into the reaction chamber (deposition chamber) together with a carrier gas consisting of an inert gas, such as argon or so on. The carrier gas may also consist of N₂ or the like. Oxygen gas is introduced in the deposition chamber via a line separated from the supply lines for the evaporating sources. A substrate for undergoing the deposition of the contemplated ceramic film thereon is placed inside the deposition chamber. The substrate can be heated with a suitable heating means located within the deposition chamber or by a heating means arranged outside the deposition chamber. It is possible to employ other means for heating, such as highfrequency heating.

Over the so heated substrate, an inert carrier gas containing the vaporized β-diketone complexes for the elements constituting the superconducting oxide thin film and oxygen gas is supplied. The heating temperature for the substrate should be at least that required for effecting sufficient decomposition of the β-diketone complexes and attaining the polymerization (crystal growth) and should be a temperature at which the substrate will riot suffer from any denaturation. The temperature, therefore, is in the range from 800°C to below 1000°C.

The deposition chamber is under a reduced pressure, because it is preferable to choose a reduced pressure for producing superconducting oxide film of better quality.

The thickness of the film to be formed on the substrate can be adjusted voluntarily by controlling the deposition duration and the heating temperature of the vaporizing sources. The control of the chemical composition of the superconducting oxide film formed on the substrate can be effected by controlling the heating temperature of each vaporizing source and the flow rate of the carrier gas. The proportion of oxygen in the superconducting oxide film formed on the substrate can be controlled by controlling the oxygen partial pressure by adjusting the feed rate of oxygen gas. This can also be controlled as in conventional technique of producing superconducting oxide by incorporating a heat treatment in an atmosphere of air or of oxygen gas. Heat treatment may be effected during cooling period after the deposition of the superconducting oxide film on the substrate.

By the procedures as described above, the superconducting oxide film is synthesized at a temperature lower than the temperature for the production of sintered material thereof and the chemical composition of the film can be controlled by the heating temperature of each of the starting vaporizing sources. namely, β-diketone complexes, and by adjusting the flow rate of the carrier gas. The adjustment of the feed rate of oxygen can also be effected in the same deposition apparatus. According to the present invention, the superconducting oxide film can be deposited on a substrate of large size having a large surface area of complicate configuration.

The present invention implies also a technique in which starting materials containing the essential three elements, namely, barium, yttrium and copper are heated each to a temperature at which contemplated vapor phase containing each of these elements is obtained and the vapors of these elements are introduced into the reaction chamber at a portion near the substrate or above the substrate each in a form of a gas stream containing barium, yttrium or copper accompanied by a carrier gas of inert gas, in order to effect sufficient mixing and decomposition with polymerization. Oxygen gas or an oxygen-containing gas is introduced into the reaction chamber via a line separated from the line of the carrier gas. The substrate to be employed is a single crystal. It is preferable, however, to employ a substrate having a heat expansion coefficient identical or close to that of the superconducting oxide film formed thereon, such as, zirconia, magnesia and alumina, in order to prevent the superconducting oxide film to get off from the substrate, since the oxide film is synthesized at a temperature quite above room temperature and will be brought to practical use at a quite low temperature near the temperature of liquid nitrogen or even below it.

The substrate is heated at a temperature in the range from 800°C to below 1000°C by a suitable heating means installed within the deposition chamber or by a high frequency heating. For obtaining an oxide film with high epitaxial orientation in the crystal structure, a higher temperature above 850°C may be preferable.

The pressure inside the deposition chamber is a reduced pressure at which each partial pressure of each starting vaporing source is sufficient for building up the contemplated oxide film and, in general, a pressure of about 1333 Pa (10 Torr) may be preferred.

It has been known that the molar proportion of oxygen in a ceramic superconducting oxide takes an indefinite value of y = 0 - 1 and can be controlled by a heat treatment in an atmosphere of air or an oxygen-containing gas, as in the conventional technique for the production of superconducting oxide material. This can also be controlled by controlling the oxygen partial pressure inside the reaction chamber by adjusting the feed rate of oxygen gas.

In the process according to the present invention, in which superconducting oxide film is deposited on a substrate by means of chemical vapor phase deposition using vaporizing sources for elements including at least barium, yttrium and copper and a carrier gas carrying vapors of said vaporizing sources and oxygen gas or an oxygen-containing gas, the oxygen content in the oxide film formed on the substrate can easily be adjusted by controlling the partial pressure of oxygen in the feed gas, so that the superconducting oxide film can be deposited on a substrate of large size having large surface area and complicate configuration in a form of thin film having a crystal structure epitaxial orientation in the direction of [0,0,1] at a temperature lower than the temperature for producing a sintered product of such superconducting oxide material.

In the process according to the present invention, an inert gas is employed forthe carrier gas for entraining each vapor of the vaporizing sources and oxygen gas or an oxgen-containing gas to carry them into the reaction chamber in which the heated substrate is exposed to them. The temperature lies in the range from 800 to 1000°C. This heating temperature of the substrate should be above the temperature at which the β-diketone complexes are decomposed completely and are brought to association with each other but lower than the temperature for forming sintered product of the deposited superconducting oxide. The deposition chamber is held under a reduced pressure which may preferably be at around 1333 Pa (10 Torr).

The thickness of the deposited oxide film can voluntarily be controlled by selecting adequately the deposition duration, the heating temperature of the various sources and the flow rate of the carrier gas. In order to obtain an oxide film having high crystallinity by epitaxial crystal growth, the deposition rate should be lowered as low as possible.

The chemical composition of the superconducting oxide film can be controlled by adjusting the heating temperature of the vaporizing sources and the flow rate of the carrier gas. The content of oxygen in the deposited oxide film is controlled by controlling the oxygen partial pressure by adjusting the feed rate of oxygen. The cooling of the so deposited oxide film may be effected under an atmosphere of the carrier gas with the same oxygen partial pressure or in the atmosphere of air or in an oxygen-containing gas with oxygen partial pressure of 1 atm. The rate of cooling may either be effected as a gradual cooling with a cooling rate of about 1 °C/min or as a rapid cooling with a cooling rate of about 30 °C/min.

A stable control of the chemical composition of the superconducting oxide film deposited on the substrate by the process as described above can be realized by the control of heating temperature of the vaporizing sources and the flow rate of the carrier gas.
whereby an oxide film having a superior superconducting property can be obtained simply by effecting the cooling of the deposited oxide film in situ in the deposition chamber after the deposition has been completed.

### Detailed Description of the Preferred Embodiments

Below, the present invention will further be described by way of several Examples.

### Reference Example 1

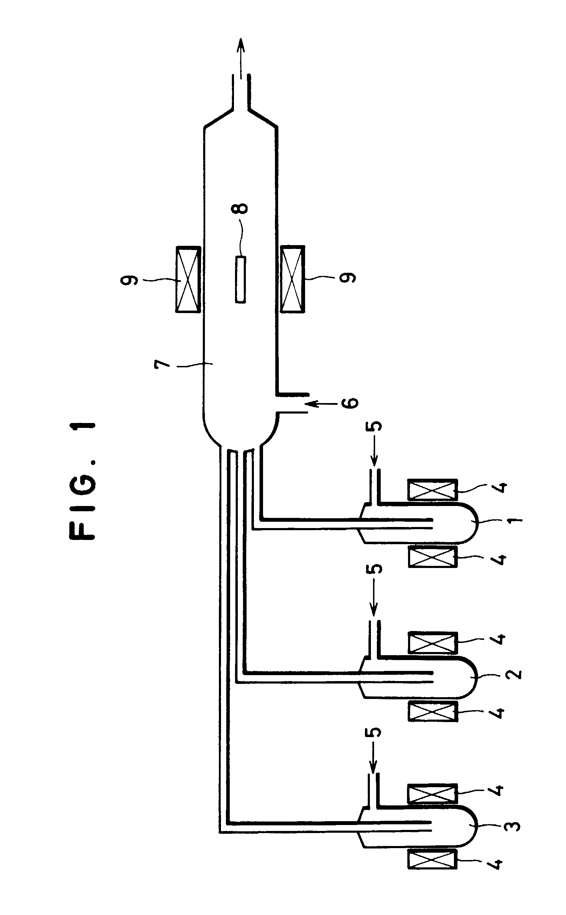

Using an apparatus as illustrated schematically in Fig. 1, which shows one embodiment of the apparatus for carrying out the process according to the present invention, the starting components, namely, vaporizing sources for barium, yttrium and copper, each in a form of a complex with β-diketone, i.e. Y(C₁₁H₁₉O₂)₃, Ba(C₁₁H₁₉O₂)₂ and Cu(C₁₁H₁₉O₂)₂, are charged each in a vaporizing source storage vessel 1, 2 and 3 respectively and are heated each by a heater 4. The heating temperature for the β-diketone complex of yttrium in the vessel 1 is adjusted at 130 °C, that for the β-diketone complex of barium in vessel 2 at 250°C and that for the β-diketone complex of copper in vessel 3 at 150 °C. Into each of the storage vessels 1, 2 and 3, argon gas as the carrier gas is fed from an inert gas inlet 5 at a flow rate of 50 ml/min. At the same time, oxygen gas is introduced into the deposition chamber from an oxygen inlet 6 at a flow rate of 100 ml/min. The carrier gas streams containing each vapor of β-diketone complexes are mixed with oxygen gas within the reaction chamber 7 and the resulting gas mixture is fed onto the heated substrate 8. The substrate is heated by a substrate heater 9 to a temperature of 800°C. The reaction chamber is maintained under a reduced pressure.

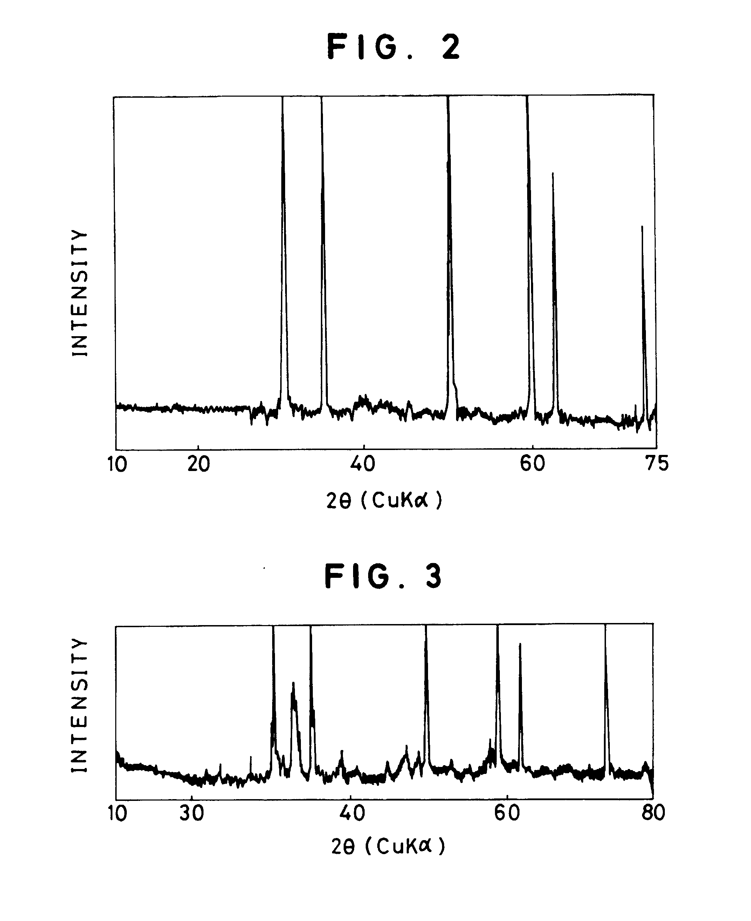

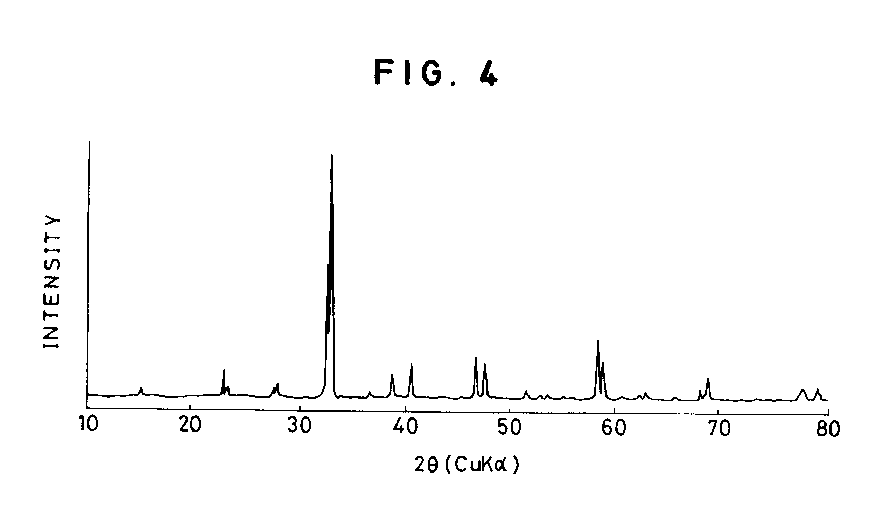

Under the condition as described above, the deposition of the ceramic film was realized on the substrate made of zirconia over a period of 3 hours. The thickness of the so obtained ceramic film amounted to 3 - 4 µm. Fig. 2 shows the X-ray spectroscopic chart for the zirconia substrate employed and Fig. 3 is a corresponding chart for the superconducting oxide film obtained in this Example. For the sake of comparison, an X-ray spectroscopic chart for a ceramic material of Ba₂YCu₃O_{7-y} which had shown a superconductivity critical temperature of 90 °K is recited in Fig. 4. As is clear from these three charts, the film obtained on the zirconia substrate had the same crystal phase as that shown in Fig. 4.

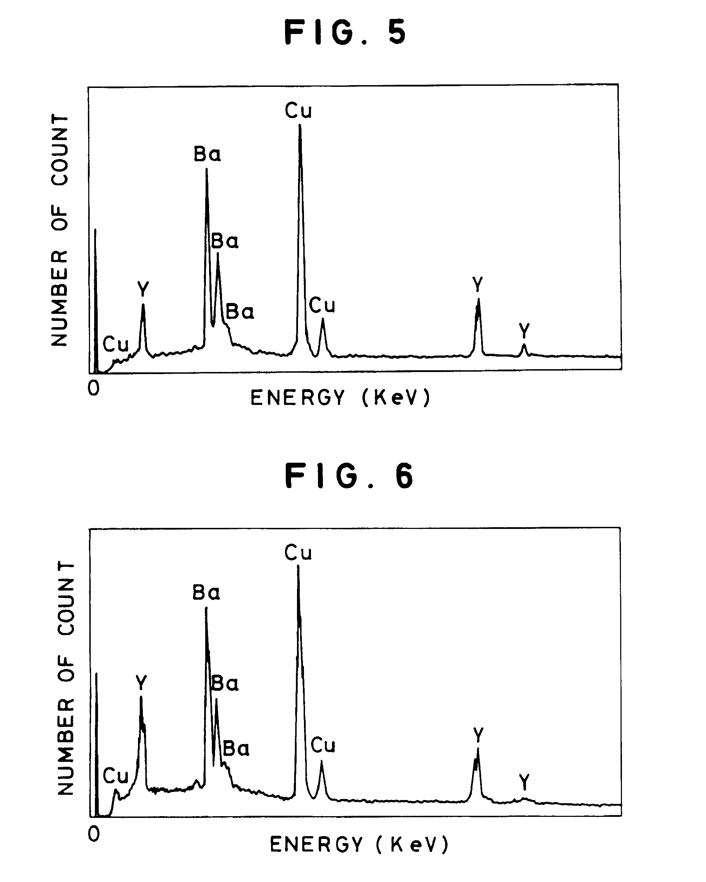

The deposited oxide film was then analytically investigated for the elements barium, yttrium and copper using an analysis electron microscope. Fig. 5 is the resulting diffraction chart. For the sake of comparison, a similar diffraction chart obtained under the same condition using same microscope for a superconducting oxide material synthesized by the sintering technique is recited in Fig. 6. As is seen from Fig. 5, the atomic ratio of the ceramic film is calculated to be

Ba : Y : Cu = 2 : 1 : 3

which is the same to that of the above mentioned superconducting oxide, material having superconducting critical temperature of 90 °K.

### Reference Example 2

In this Example, the starting β-diketone complexes for barium, yttrium and copper were Y(C₁₁H₁₉O₂)₃, Ba(C₁₁H₁₉O₂)₂ and Cu(C₅HF₆O₂)₂ respectively. They were charged in the vessels 1, 2 and 3 respectively and were heated each by the heater 4. The temperature for each vessel was chosen to be 130°C, 250 °C and 90 °C respectively. Into each container, a carrier gas consisting of argon was introduced from inert gas inlet 5 each at a flow rate of 50 ml/min. The substrate 8 inside the reaction chamber was heated to 900 °C by the heater 9. The reaction chamber was held under a reduced pressure.

Under the condition as above, the deposition of oxide film was effected on the substrate made of zirconia over a period of 4 hours. The so obtained oxide film gave the same X-ray diffraction data as given in Fig. 3 in Example 1.

### Reference Example 3

In this Example, the starting β-diketone complexes for yttrium, barium and copper charged in the vessels 1, 2 and 3 are heated each to a temperature of 120°C, 220 °C and 115°C respectively. The inert gas consisting of argon is introduced into each vessel each at a flow rate of 10 ml/min from the inert gas inlet 5. Oxygen gas is introduced at the same time into the reaction chamber from the oxygen inlet 6 at a flow rate of 100 ml/min.

These gas streams for the component elements of the oxide film are mixed sufficiently within the reaction chamber 7 so as to cause the requisite reaction between the components. The resulting gas mixture is supplied onto the surface of the substrate 8 located near the gas mixing zone. In this Example, the substrate is made of zirconia. The substrate 8 is heated to 800°C by the substrate heater 9. The reaction chamber is maintained under a reduced pressure of 1333 Pa (10 Torr) using a vacuum pump 10.

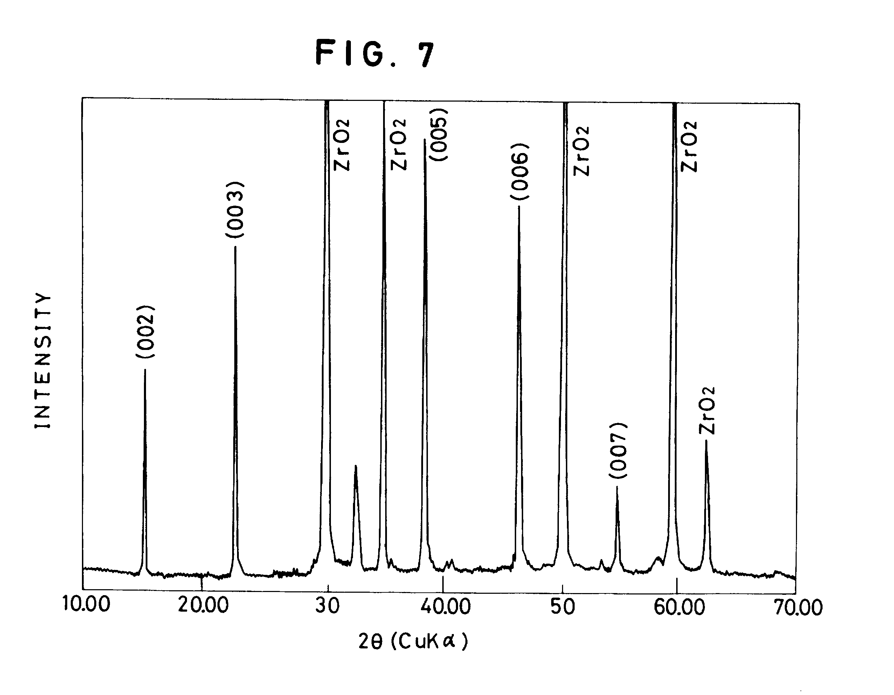

Under the condition as above, the deposition of the oxide film was effected over a period of 2 hours. The thus obtained oxide film gave an X-ray spectroscopic chart as recited in Fig. 7, from which it is made clear that this film was composed of Ba₂YCu₃O_{7-y} and has a strong orientation in the crystal structure in the direction of [0,0,1].

### Reference Example 4

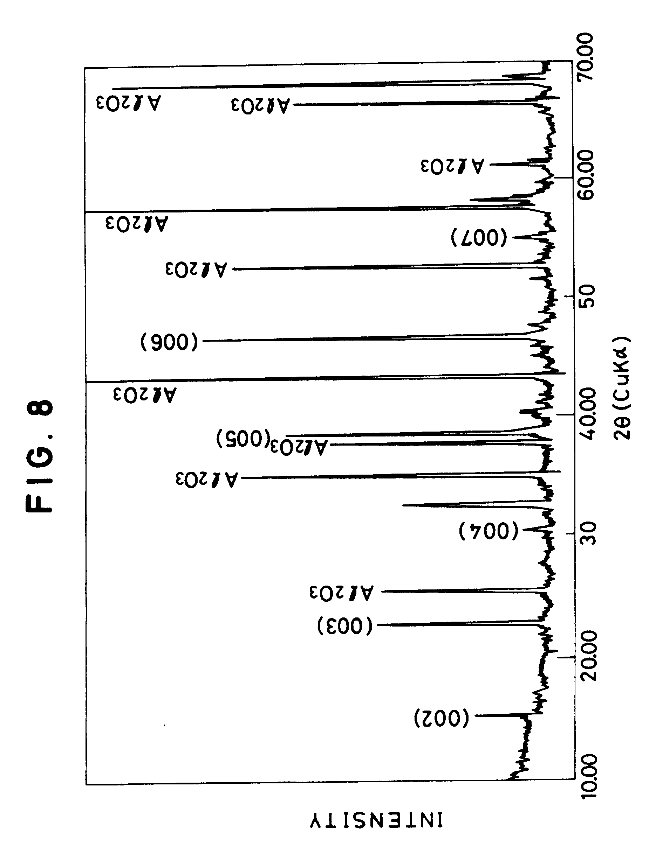

This Example represents the case in which the gas flow rate for argon is settled at 60 ml/min and the substrate is heated at 900°C with the other conditions equal to those in Example 1 with the exception that the substrate is made of alumina. The X-ray spectroscopic chart of the oxide film obtained is given in Fig. 8, from which it is made clear that the oxide film deposited on alumina substrate is also highly oriented in its crystal structure in the direction of [0,0,1].

### Reference Example 5

This Example shows the case in which sapphire substrate is employed under the same condition as in Example 4.

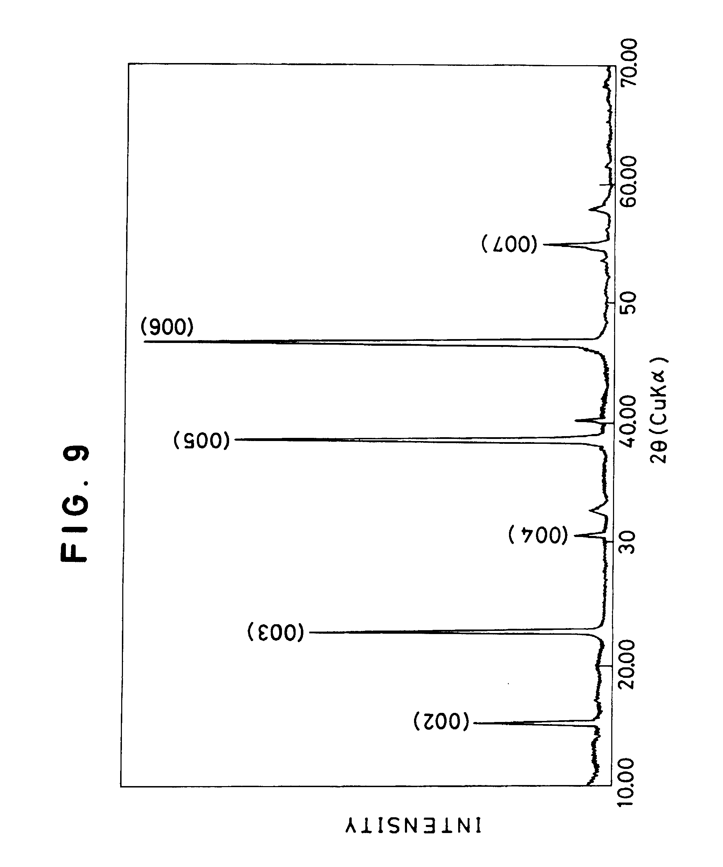

The X-ray spectroscopic chart of the oxide film obtained is given in Fig. 9, from which it is made clear that the oxide film deposited on sapphire substrate is also highly oriented in its crystal structure in the direction of [0,0,1].

### Example 1

Vaporizing sources for yttrium, barium and copper in the form of Y(C₁₁H₁₉O₂)₃, Ba(C₁₁H₁₉O₂)₂ and Cu(C₁₁H₁₉O₂)₂ respectively are charged each in the storage vessel 1, 2 and 3 respectively and are heated each by heater 4. The heating temperature for the vessels 1, 2 and 3 are 115 °C, 235 °C and 110°C respectively. Into each of the storage vessels 1, 2 and 3, argon gas as the carrier gas is fed from the inert gas inlet 5 at a flow rate of 60 ml/min. At the same time, oxygen gas is introduced into the deposition chamber from the oxygen inlet 6 at a flow rate of 100 ml/min. The carrier gas streams containing each vapor of β-diketone complexes are mixed with oxygen gas within the reaction chamber 7 and the resulting gas mixture is fed onto the surface of a heated substrate 8 made of single crystal of strontium titanate [1,0,0]. The substrate is heated by substrate heater 9 to a temperature of 900 °C. The reaction chamber is maintained under a reduced pressure of 1333 Pa (10 Torr).

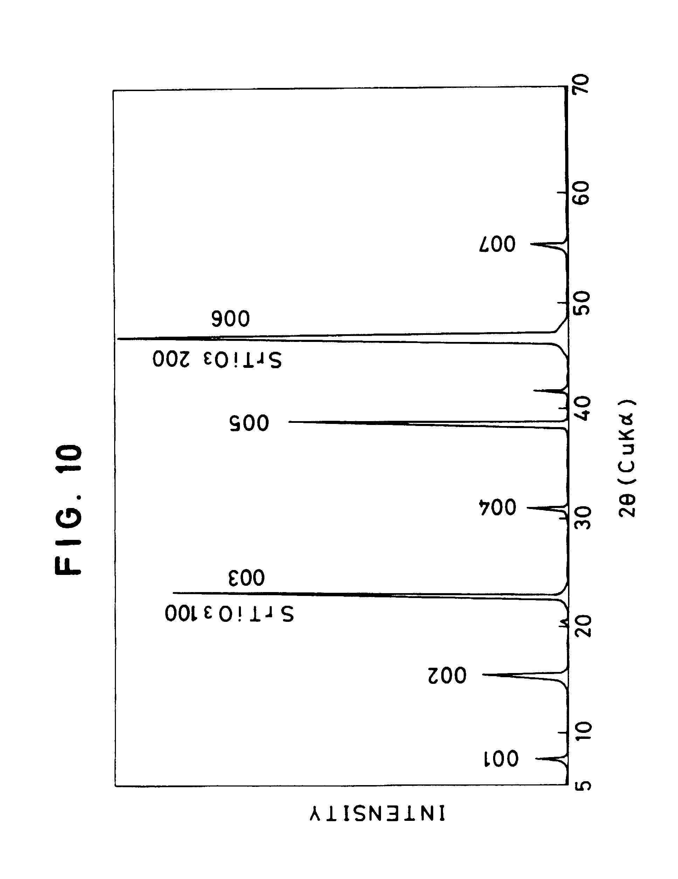

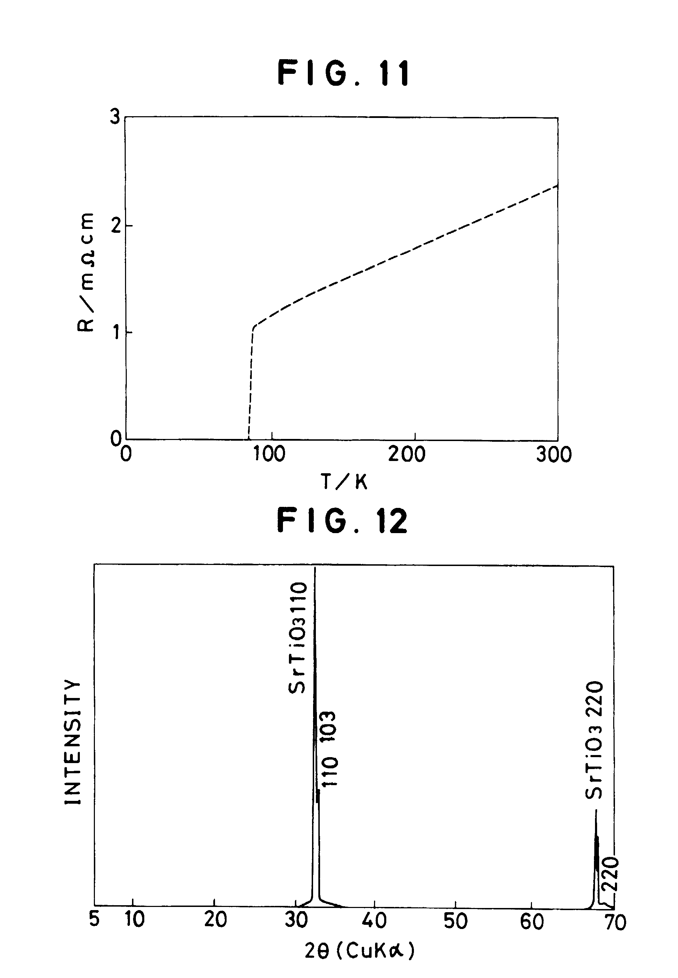

Under the condition as above, the deposition of the oxide film is effected on the [1,0,0] surface of the strontium titanate substrate over a period of one hour with subsequent cooling to room temperature over a period of one hour. The thickness of the oxide film obtained is found to be 0.7 µm. X-ray diffraction analysis chart of this oxide film is given in Fig. 10, which shows only the diffraction peaks for the plane [0,0,1], what indicates clearly that the film had grown epitaxially. The relationship between the specific resistance and the temperature of the oxide film obtained is given as a graph in Fig. 11. As shown, the electric resistance decreases from about 90 °K and reaches zero at 84 °K, indicating attainment of superconducting condition. The critical current density of the oxide film obtained lies at a value of 5 × 10⁵ A/cm² or more at 77 °K in magnetic field of zero strength.

### Example 2

This Example illustrates the case wherein the conditions of Example 1 are followed with the exception that the heating temperature of the substrate is chosen at 800°C. The oxide film obtained gave an X-ray spectrographic chart similar to that of Example 1, showing the evidence that this oxide film had grown epitaxially.

### Example 3

In this Example, the β-diketone complex of barium was heated to 240 °C, the β-diketone complex of yttrium to 120 °C and the β-diketone complexes of copper to 115°C respectively. Under the conditions of internal pressure of 1333 Pa (10 Torr), a carrier gas flow rate of 60 ml/min, an oxygen gas feed rate of 100 ml/min and a substrate heating temperature of 900 °C, the deposition of oxide film on the [1,1,0]-surface of a single crystal plate of strontium titanate is effected over a period of one hour with subsequent cooling to room temperature within 1 hour. The thickness of the oxide film obtained amounted to 1 µm. The X-ray spectrographic chart of this oxide film is given in Fig. 12, which shows that the film consists of a part formed by epitaxial crystal growth in the direction of [1,1,0] and a part formed by epitaxial crystal growth in the direction of [1,0,3]. Also this oxide film revealed a superconducting critical temperature above the temperature of liquid nitrogen as in the case of Example 1.

### Example 4

This Example describes the case in which the substrate temperature is chosen at 800°C with the other conditions being the same as in Example 3. The oxide film obtained gave an X-ray spectrographic chart similar to that in Example 3. showing that the film was formed by epitaxial crystal growth.

As described above with reference to several Examples, the process according to the present invention can afford to provide superconducting materials of specific oxide type in the form of thin film having a highly oriented epitaxial crystal structure by chemical vapor deposition on various substrates without being restricted by their configuration easily at lower temperature than that required for producing corresponding sintered superconducting ceramic film.

The oxide thin film of Ba₂YCu₃O_{7-y} formed by epitaxial crystal growth obtained according to the present invention has a superior superconducting property and can be prepared in higher productivity in a quite stable manner, so that it permits to meet the requirements for utilization in a wide variety of applications.

## Claims

1. A process for manufacturing thin film of high-T_{c} superconducting oxide by means of chemical vapor deposition technique using vaporizing sources for the metal elements constituting the superconducting oxide and a carrier gas with oxygen, comprising forming a ceramic thin film by chemical vapor deposition with epitaxial crystal growth under reduced pressure on a substrate at a temperature of at least 800°C and below 100°C from β-diketone complexes of the elements including at least barium, yttrium and copper.

2. A process according to claim 1, wherein the compositional ratio of the elements of superconducting oxide is adjusted by controlling the flow rate of the carrier gas and the heating temperature for each vaporizing source.

3. A process according to claim 1, wherein a heat treatment of the oxide thin film formed on the substrate is effected successively in situ in the deposition chamber.

4. A process according to claim 1, wherein the substrate consists of a single crystal.

5. A process according to claim 1, wherein the substrate consists of a single crystal of strontium titanate and is heated to a temperature of 800 - 950°C.

## Patentansprüche

1. Verfahren zur Herstellung eines Dünnfilms eines Hoch-T_{c} Oxid-Supraleiters durch chemische Aufdampftechnik unter Verwendung von Verdampfungsquellen für die den Oxid-Supraleiter bildenden Metallelemente und eines Trägergases mit Sauerstoff, umfassend die Bildung eines keramischen Dünnfilms durch chemisches Aufdampfen mit epitaxialem Kristallwachstum unter vermindertem Druck auf einem Substrat bei einer Temperatur von mindestens 800°C und unterhalb 1000°C aus β-Diketonkomplexen der Elemente, die mindestens Barium, Yttrium und Kupfer umfassen.

2. Verfahren gemäß Anspruch 1, wobei das Zusammensetzungsverhältnis der Elemente des Oxid-Supraleiters eingestellt wird, indem man die Flußrate des Trägergases und die Heiztemperatur für jede Verdampfungsquelle steuert.

3. Verfahren gemäß Anspruch 1, wobei eine Wärmebehandlung des auf dem Substrat gebildeten Oxiddünnfilms darauffolgend in-situ in der Abscheidungskammer bewirkt wird.

4. Verfahren gemäß Anspruch 1, wobei das Substrat aus einem Einkristall besteht.

5. Verfahren gemäß Anspruch 1, wobei das Substrat aus einem Einkristall aus Strontiumtitanat besteht und auf eine Temperatur von 800-950°C erhitzt wird.

## Revendications

1. Procédé pour la fabrication d'une couche mince d'oxyde supraconducteur de T_{c} élevée au moyen d'une technique de dépôt chimique en phase vapeur utilisant des sources vaporisantes pour les éléments métalliques constituant l'oxyde supraconducteur et un gaz porteur avec de l'oxygène, comprenant la formation d'une couche mince céramique par dépôt chimique en phase vapeur avec croissance épitaxiale du cristal sous pression réduite sur un substrat à une température d'au moins 800°C et inférieure à 1000°C à partir de complexes de dicétones-β des éléments comprenant au moins le baryum, l'yttrium et le cuivre.

2. Procédé selon la revendication 1, dans lequel le rapport de composition des éléments de l'oxyde supraconducteur est ajusté en contrôlant le débit du gaz porteur et la température de chauffage pour chaque source vaporisante.

3. Procédé selon la revendication 1, dans lequel un traitement thermique de la couche mince d'oxyde formée sur le substrat est réalisé successivement in situ dans la chambre de dépôt.

4. Procédé selon la revendication 1, dans lequel le substrat consiste en un monocristal.

5. Procédé selon la revendication 1, dans lequel le substrat consiste en un monocristal de titanate de strontium et est chauffé à une température de 800-950°C.
